# EUROPEAN PATENT APPLICATION

(11) **EP 1 294 018 A1**
(43) Date of publication of application: **19.03.2003**
(21) Application number: 01122221.3
(22) Date of filing: 17.09.2001
(51) Int. Cl.: H01L 21/762

(54) **Silicon on insulator substrate and method for manufacturing said substrate**

(71) Applicant: Infineon Technologies AG, 81669 München (DE)
(72) Inventor: Birner, Albert, Dr., 01129 Dresden (DE); Goldbach, Matthias, Dr., 01099 Dresden (DE)
(74) Representative: Epping Hermann & Fischer

(57) **Abstract**

A trench (25) comprising a side wall (26) and a ground portion (27) is formed in a substrate (5) and covered with an isolating liner layer (30). The isolating liner layer (30) is removed from the ground portion (27) of the trench (25) and the trench (25) is deepened to form a first part (40) of the trench (25) in the substrate (5). Pores (45) are formed in the substrate (5) surrounding the first part (40) of the trench (25). The substrate (5) is oxidized in an oxygen containing atmosphere at a raised temperature and silicon oxide is formed around the pores (45) in the substrate (5) to form an isolating layer (50). A silicon on insulator layer (55) remains on top of the isolating layer (50).

## Description

The present invention relates to a method for manufacturing a silicon on insulator substrate. The invention further relates to a silicon on insulator substrate.

In the technical field of silicon semiconductor manufacturing, it is known to use silicon on insulator (SOI) substrates for the manufacturing of silicon semiconductor devices with improved isolation characteristics.

To form an isolator underneath a monocrystalline silicon substrate results in low production costs and advantages for several applications. The monocrystalline silicon substrate above the isolation layer is called a silicon on insulator (SOI), which comprises advantages for logic devices and memory devices like DRAMs (Dynamic Random Access Memorys).

For example, the document US 5,888,297 describes a method for manufacturing an SOI substrate by implanting oxygen into a silicon semiconductor substrate and annealing the substrate afterwards for forming the isolating silicon oxide layer in the silicon semiconductor substrate. It has been observed, that the oxygen implantation method causes defects in the silicon on insulator layer which decrease the performance and the yield of the manufactured semiconductor devices.

The document US 6,211,041 B1 describes a method known as wafer bonding wherein a second wafer is bonded to a first wafer upside down and the second wafer is cut afterwards to leave a thin silicon layer on an isolating silicon oxide layer on top of the first wafer. The wafer bonding method for manufacturing silicon on insulator substrates is expensive and time intensive and also causes defects in the silicon on insulator layer which result in high production costs.

It is an objective of the present invention to provide a silicon on insulator substrate and a method for manufacturing said substrate with reduced tension of the silicon layer and the isolating layer of the silicon on insulator substrate and to enable a method with reduced production costs.

Concerning the substrate, the objective is achieved by a substrate comprising:
- an isolating layer arranged on said substrate;
- a silicon on insulator layer arranged on said isolating layer;
- a trench arranged in said isolating layer and said silicon on insulator layer, which is filled with a first filling material.

As an advantage, the substrate can be produced with low production costs. The trench is arranged in the substrate within the insulator and the silicon on insulator. An other advantage is, that the isolating layer underneath the silicon on insulator layer and the silicon on insulator layer itself the can be formed with very low mechanical tension and stress. Improved devices with less defects can be formed on the substrate.

According to an embodiment of the present invention, a selectively grown epitaxial layer is arranged on said silicon on insulator layer and on said filling material. This forms an active layer for semiconductor devices on top of the first filling material. In this case the devices can be formed all over the surface of the substrate and are not restricted to areas next to the trench.

Concerning the method, the objective is solved by a method for manufacturing a silicon on insulator substrate comprising the steps:
- providing a substrate comprising silicon,
- forming a trench in the substrate comprising a side wall and a ground portion;
- depositing an isolating liner layer in the trench on the side wall;
- deepening the trench to form a first part of the trench in the substrate;
- forming pores in the substrate, within the first part of the trench;
- oxidizing the substrate to form an isolating layer, wherein the substrate surrounding the pores is oxidized to silicon oxide and a silicon on insulator layer is maintained between the surface of the substrate and the isolating layer.

The inventive method forms trenches in the substrate wherein the upper part of the trench is masked with the isolating liner layer and pores like mesopores or micropores are formed in the lower part of the trench. This removes material from the substrate and forms additional space for the following oxidation. During the oxidation, oxygen is reacting with silicon to silicon oxide which leads to an increased volume. The pores formed in the substrate are narrowed and closed due to the increasement of the silicon oxide volume. Without the pores, the silicon oxide layer would comprise a high mechanical stress due to the increasement in volume. The inventive method leads to a silicon on isolator substrate with low mechanical stress and reduced defects in the silicon on insulator substrate and the silicon oxide layer. It also provides a cheap method for manufacturing the SOI substrate.

According to an embodiment of the present invention, the pores form a microporous substrate or a mesoporous substrate. Micropores typically have a diameter between 0 to 5 nm (nanometer) and a depth between 5 to 500 nm. Mesopores typically have a diameter of more than 5 nm and a similar depth.

According to another embodiment of the present invention, the pores are electrochemically etched by applying a fluorine containing electrolyte and an external voltage to the substrate. Electrochemical etching can be performed in n-type silicon or p-type silicon with a fluorine containing electrolyte and a voltage applied to the substrate. For example p-type silicon with a doping between 10¹⁴ and 10¹⁸ doping atoms per cm³ can be etched with a current density between 1 to 100 mA per cm², an anodisation voltage between 1 and 50 volts and an electrolyte containing hydrofluoric acid HF in water with a concentration between 5% and 25%.

According to another embodiment of the present invention, the pores are electrochemically etched by applying an electrolyte containing HF to NHO₃ to H₂O in a ratio of about 1 to 5 to 10 or alternatively NaNo₂ in HF or CrO₃ in HF. This mixture for the electrolyte does not need a separate voltage applied to the substrate, because the charge carriers for etching the pores are supplied by the electrolyte. Advantageously, an additional electrode is not necessary to contact the substrate. This process is also known as stain etch.

According to another preferred embodiment, the liner layer contains silicon nitride. Silicon nitride is capable of masking the upper part of the trench to prevent a mesopore formation in the top layer of the substrate and to prevent an oxidation of the top layer of the substrate resulting in a silicon on insulator layer maintained between the surface of the substrate and the isolating layer.

In another preferred embodiment of the present invention, the first part of the trench is filled with a filling material. Advantageously, the filling material is an isolator and closes the trenches in the isolating layer.

In a further preferred embodiment of the present invention, a selectively grown epitaxial layer is grown over the filling material to form the silicon on insulator layer on top of the filling material. This process step closes the silicon on insulator layer to form a monocrystalline layer also on top of the filling mass. The silicon on insulator substrate can now be used for logic devices with transistors formed in the silicon on insulator layer.

In a further embodiment, the trench is deepened a second time to form a second part of the trench and a trench capacitor of a dynamic random access memory can be formed in the second deepening. Due to the isolating layer arranged between the silicon on isolator and the lower part of the trench capacitor, the trench capacitor for the dynamic random access memory does not need an additional isolation collar. The selection transistor for the dynamic random access memory cell can be arranged in the silicon on insulator layer and shows advanced isolation characteristics due to the isolating layer.

The invention will be better understood by reference to the following description of embodiments of the invention taken in conjunction with the accompanying drawings. Equal references show equal or functionally equal components.

The figures show:
- figure 1: a cross section through a substrate with masking layers and a trench comprising an isolating liner layer;
- figure 2: the cross section according to figure 1 with a first deepening of the trench and pores formed in the substrate around the first deepening;
- figure 3: the cross section of figure 2 wherein the substrate is oxidized around the first deepened part of the trench and the pores;
- figure 4: a cross section according to figure 3 wherein a second deepened part of the trench is formed in the substrate;
- figure 5: the substrate according to figure 3 wherein the masking layers are removed, the first part is filled with a filling material and a selective epitaxial layer is formed on top of the filling material.

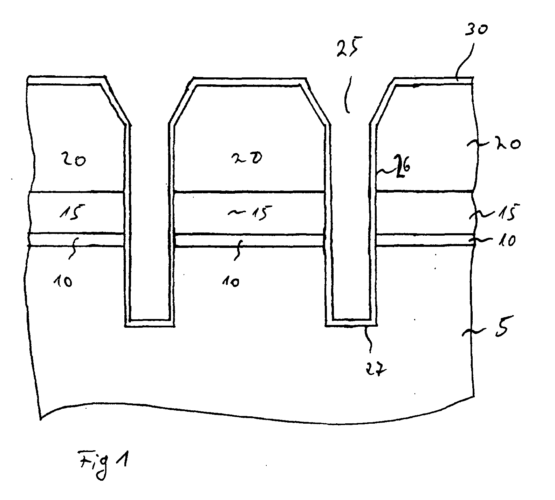

Figure 1 shows a substrate 5 containing doped or undoped mono crystalline silicon. On top of the substrate 5, a first masking layer 10, a second masking layer 15, and a third masking layer 20 are formed. For example, the first masking layer 10 is a thermal silicon oxide layer which can be formed by oxidizing the surface of the substrate 5. On top of the first masking layer 10, the second masking layer 15 is arranged and can comprise silicon nitride. The silicon nitride layer can be deposited by a chemical vapour deposition process (CVD) and is typically called pad nitride. On top of the second masking layer 15, the third masking layer 20 is formed by a chemical vapour deposition and typically comprises silicon dioxide. The third masking layer 20 forms together with the first masking layer 10 and the second masking layer 15 an etch mask for forming trenches or deep trenches in the substrate 5. The first, second, and third masking layers 10, 15, and 20 are structured by a commonly used photo lithography process with successive etching of the masking layers. Afterwards, the masking layers are used to etch a trench 25 into the substrate 5. The described masking layers 10, 15 and 20 are adequate for structuring a deep trench for a DRAM (dynamic random access memory) trench capacitor. Also a more simple masking structure, just comprising one masking layer, is suitable for forming the trench 25.

An isolating liner layer 30 is deposited in the trench 25 and on the masking layers 10, 15 and 20. The isolating liner layer 30 is deposited by a conformable deposition process like chemical vapour deposition and typically comprises silicon nitride or silicon oxide or aluminum oxide. The trench 25 comprises a side wall 26 and a ground 27. The isolating liner layer 30 is also deposited on the side wall 26 and on the ground 27.

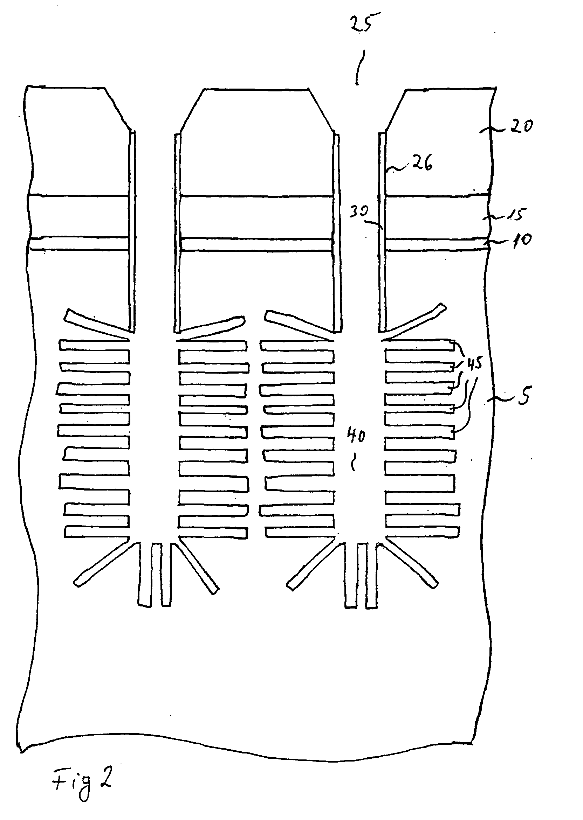

According to figure 2, the isolating liner layer 30 is removed from the ground 27 of the trench 25. This can be done with a non isotropic etching which removes the isolating liner layer 30 from horizontally arranged surfaces and leaves the isolating liner layer 30 on the side wall 26. In a following process step, a first deepened part 40 of the trench 25 is formed in the substrate 5. This prolongs the trench into the substrate 5.

The side wall 26 of the trench 25 is still protected by the isolating liner layer 30 in its upper part. The first part 40 of the trench 25 is now etched in a fluorine containing electrolyte with an additional voltage applied to the substrate 5. This etches pores 45 around the first part 40 into the substrate 5. The pores 45 can also be etched by an electrolyte containing HF to NHO₃ to H₂O in a ratio of about 1 to 5 to 10 or alternatively NaNo₂ in HF or CrO₃ in HF, which does not need an additional voltage source applied to the substrate. The etching process does not use a closed current circuit and is known as stain etch, i.e. an etching process without a current circuit. An additional advantage of this process is, that no additional electrode is needed to contact the substrate 5. The pores can be etched with a high depth into the silicon substrate, wherein the depth mainly depends on the time the etching is performed. The pores typically can be formed with several hundred nanometers depth.

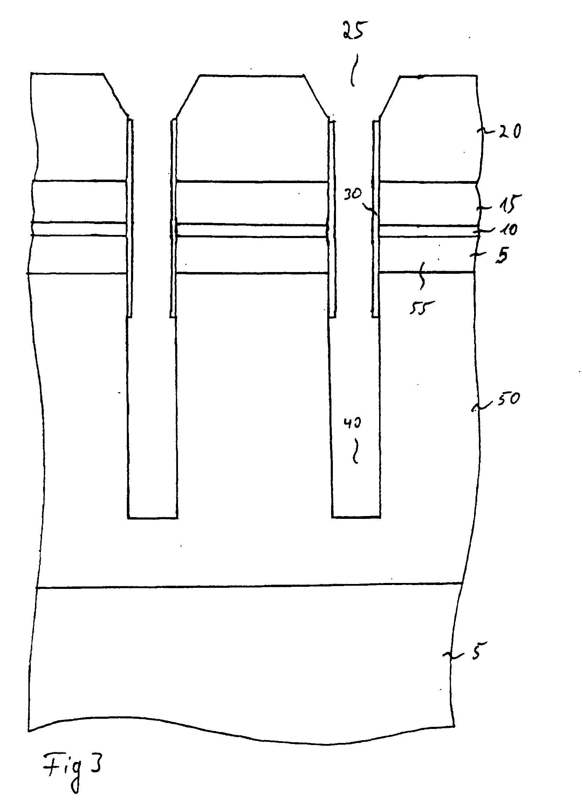

With reference to figure 3, the substrate is oxidized at a temperature above 900°C in dry or wet atmosphere to form an oxide between 10 to 20 nm in a time period of roughly 2 hours in a batch or single wafer process tool in oxygen containing atmosphere. The oxidisation is also depending on the doping of the substrate 5.

This forms a silicon oxide layer 50 and maintains a silicon on insulator layer 55 between the surface of the substrate 5 and the isolating layer 50. Because of the pores in the substrate 5, the volume increasement due to the oxidation of the silicon can be compensated by the pores and does not lead to an additional mechanical tension and stress in the silicon on insulator layer 55 or the isolating layer 50.

Several trenches 25 are arranged in the substrate 5 and a locally arranged silicon on insulator layer can be manufactured. It is also possible to manufacture silicon on insulator layers with a different thickness on the same substrate, just depending on the depth of the trench 25 and the depth of the isolating liner 30 arranged on the side wall 26 of the trench 25.

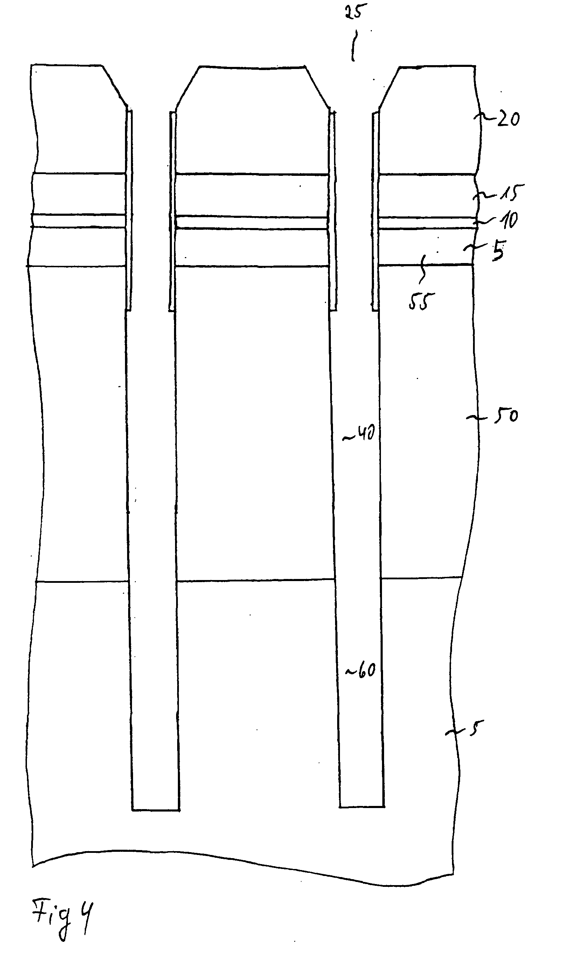

According to figure 4, a second part 60 of the trench is formed in the substrate 5 as a deep portion of the trench 25. A trench capacitor can be formed in the second part 60 of the trench 25 as a part of a dynamic random access memory cell. A selection transistor for the memory cell connected to the trench capacitor can be arranged in the silicon on insulator layer 25 on top of the isolating layer 50.

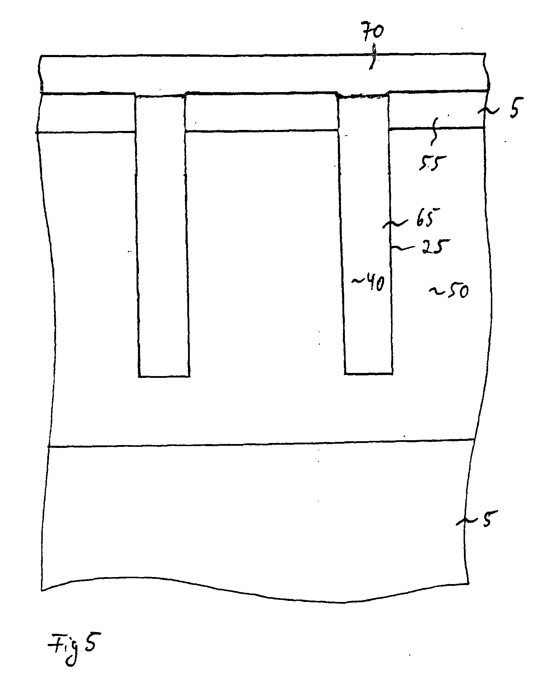

According to figure 5, another embodiment of the present invention based on figure 3 is shown. The first deep part 40 is filled with a filling material 65. The filling material 65 is preferably an isolator and typically comprises silicon oxide. The filling 65 can also consist of polycrystalline silicon. On top of the filling material 65 and the silicon on insulator 55, an epitaxial layer 70 is grown to form a monocrystalline silicon layer. The selective epitaxial process grows the selective epitaxial layer 70, starting from the silicon on insulator layer 55 growing on the silicon on insulator layer 55 and sidewards over the isolating filling 65. The substrate shown in figure 5 can advantageously be used for logic circuits with field effect transistors formed in the epitaxial layer 70 or the silicon on insulator layer 55.

### List of reference numerals

- 5: substrate
- 10: first masking layer
- 15: second masking layer
- 20: third masking layer
- 25: trench
- 26: side wall of trench
- 27: ground of trench
- 30: isolating liner layer
- 40: first deepening of trench
- 45: pore
- 50: isolating layer
- 55: silicon on insulator layer
- 60: second deepening of trench
- 65: filling of first deepening
- 70: selective epitaxial layer

## Claims

1. Substrate (5) comprising:
- an isolating layer (50) arranged on said substrate (5);
- a silicon on insulator layer (55) arranged on said isolating layer (50) ;
- a trench (25) arranged in said isolating layer (50) and said silicon on insulator layer (55), which is filled with a first filling material (65).

2. Substrate (5) according to claim 1,
**characterised in that**
a selectively grown epitaxial layer (70) is arranged on said silicon on insulator layer (55) and on said filling material (65).

3. Method for manufacturing a silicon on insulator substrate comprising the steps:
- providing a substrate (5) comprising silicon,
- forming a trench (25) in the substrate (5) comprising a side wall (26) and a ground portion (27);
- depositing an isolating liner layer (30) in the trench (25) on the side wall (26);
- deepening the trench (25) to form a first part (40) of the trench (25') in the substrate (5) ;
- forming pores (45) in the substrate (5) within the first part (40) of the trench (25);
- oxidizing the substrate (5) to form an isolating layer (50), wherein the substrate (5) surrounding the pores (45) is oxidized to silicon oxide and a silicon on insulator layer (55) is maintained between the surface of the substrate (5) and the isolating layer (50).

4. Method according to claim 3,
**characterised in that**
the isolating liner layer (30) is also deposited on the ground portion (27) and the isolating liner layer (30) is removed from the ground portion (27) before the step of deepening (40) is performed.

5. Method according to one of the claims 3 or 4,
**characterised in that**
the pores (45) form a microporous substrate (5) or a mesoporous substrate (5).

6. Method according to one of the claims 3 to 5,
**characterised in that**
the pores (45) are electrochemically etched by applying a fluorine containing electrolyte and an external voltage to the substrate (5).

7. Method according to one of the claims 3 to 5,
**characterised in that**
the pores (45) are electrochemically etched by applying an electrolyte containing HF to NHO₃ to H₂O in a ratio of about 1 to 5 to 10 or alternatively NaNo₂ in HF or CrO₃ in HF to carry out a stain etch.

8. Method according to one of the claims 3 to 7,
**characterised in that**
the liner layer (30) contains silicon nitride.

9. Method according to one of the claims 3 to 8,
**characterised in that**
the first part (40) of the trench (25) is filled with a filling material (65).

10. Method according to one of the claims 3 to 9,
**characterised in that**
a selectively grown epitaxial layer (70) is grown over the filling material (65) to form the silicon on insulator layer (55) on top of the filling material (65).

11. Method according to one of the claims 3 to 8,
**characterised in that**
the trench (25) is deepened a second time to form a second part (60) of the trench and a trench capacitor of a dynamic random access memory is formed in the second part (60) of the trench.
